# FASCICULE DE BREVET EUROPEEN

(11) **EP 1 098 556 B1**
(45) Date de publication et mention de la délivrance du brevet: **07.02.2007**
(21) Numéro de dépôt: 00402847.8
(22) Date de dépôt: 16.10.2000
(51) Int. Cl.: H05K 3/00, G01B 11/00, G03F 9/00

(54) **Dispositif de mesure d'erreur de position relative**
Einrichtung zur Bestimmung eines Positionsfehlers
Device for measuring a positioning error

(30) Priorité: 03.11.1999 FR 9913725
(43) Date de publication de la demande: 09.05.2001
(73) Titulaire: AUTOMA-TECH, 27100 Val de Reuil (FR)
(72) Inventeur: Boureau, Damien, 76000 Rouen (FR); Clavier, David, 76100 Rouen (FR)
(74) Mandataire: Dronne, Guy

(56) Documents cités:
- EP-A- 0 618 505
- EP-A- 0 827 035
- DD-A- 241 562

## Description

La présente invention a pour objet un dispositif de mesure d'erreur de position relative entre un faisceau laser et une pièce ainsi que des applications de ce dispositif à la réalisation d'une machine d'exposition de panneaux de circuit imprimé.

On sait que, pour la fabrication de circuits imprimés par des procédés classiques, une des étapes consiste à recouvrir la couche conductrice du panneau de circuit imprimé d'une couche de matériau de réserve et à insoler cette couche de réserve à travers un cliché permettant d'obtenir la forme des pistes conductrices que l'on veut obtenir sur le circuit imprimé. Après insolation de cette couche de réserve, on procède à l'enlèvement des zones non-insolées correspondant aux portions de la couche conductrice que l'on veut enlever.

On sait également qu'il se développe une autre technique de réalisation de panneaux de circuit imprimé dans laquelle la couche de réserve est impressionnée localement par l'impact d'un faisceau laser. La position de l'impact du faisceau laser sur le panneau est commandée le plus souvent par un ensemble de balayage comportant un miroir polygonal rotatif combiné à un dispositif d'interruption commandé du faisceau laser qui est le plus souvent constitué par un modulateur acousto-optique.

D'autres techniques qui utilisent également un faisceau laser consistent, soit à réaliser directement l'ablation de la couche de réserve à l'aide d'un faisceau laser, soit à ne pas utiliser une couche de réserve et à réaliser directement l'ablation de la couche conductrice avec un faisceau laser.

Le nombre de points d'impact de faisceaux laser étant bien sûr très important pour réaliser avec la précision requise un panneau de circuit imprimé de grande dimension, il est intéressant de pouvoir diviser la surface du panneau de circuit imprimé en un certain nombre de zones et de balayer simultanément chacune de ces zones à l'aide d'un faisceau laser.

Dans les machines qui permettent de réaliser cette opération et que l'on appellera ultérieurement machines d'exposition, il se pose deux problèmes principaux de positionnement relatif. D'une part, il est nécessaire de calibrer avec précision la position du faisceau laser ou de chaque faisceau laser par rapport au bâti de la machine d'exposition et d'autre part, il est nécessaire de positionner avec une grande précision sur le bâti de la machine le panneau de circuit imprimé destiné à être insolé par faisceau laser.

En ce qui concerne la calibration du faisceau laser, on comprend que dans cette machine, celui-ci est dirigé vers le panneau de circuit imprimé à travers un bloc optique qui comporte un grand nombre de composants optiques. En outre, le balayage du panneau de circuit imprimé est obtenu le plus souvent à l'aide d'un miroir polygonal rotatif dont la rotation de chaque face définit en partie une longueur de balayage. Par ailleurs, le dessin qui doit être réalisé à l'aide du faisceau laser est défini à partir d'informations mémorisées qui donnent pour chaque point du panneau soit une information d'impact, soit une information d'absence d'impact.

On comprend qu'au vu de tous ces éléments, quelle que soit la précision des réglages initiaux de ces différents composants, il est nécessaire avant chaque utilisation de la machine de vérifier la position réelle de l'impact d'un faisceau laser par rapport au bâti de la machine.

En ce qui concerne le positionnement du panneau par rapport au bâti de la machine, on comprend que celui-ci doit également être réalisé avec une très grande précision, notamment dans le cas où les panneaux de circuit imprimé sont destinés à former les éléments constitutifs de circuit imprimé multicouches. On rappelle que le positionnement des panneaux de circuit imprimé par rapport au bâti de machine est le plus souvent obtenu à l'aide de trous circulaires réalisés en certains endroits du panneau défini avec précision.

Un objet de la présente invention est de fournir un dispositif de mesure d'erreur de position relative entre un faisceau laser et une pièce qui peut par exemple être le bâti d'une machine d'exposition ou un panneau de circuit imprimé qui permet de façon simple d'obtenir une détermination d'erreur avec une très grande précision.

Pour atteindre ce but selon l'invention, le dispositif de mesure d'erreur de position relative entre un faisceau laser et une pièce se caractérise
en ce que ladite pièce est munie d'un orifice circulaire occupant une position de référence par rapport à ladite pièce
et en ce qu'il comprend en outre :
- des moyens pour focaliser le faisceau laser dans le plan de ladite pièce,
- des moyens pour prendre une image dudit trou circulaire et du faisceau focalisé dans le plan de ladite pièce ; et
- des moyens pour calculer les composantes du segment joignant ledit point d'impact et le centre dudit trou.

On comprend que grâce à l'invention, on obtient effectivement une détermination très précise de l'erreur notamment du fait que le positionnement des moyens de prise d'image, par exemple une caméra, n'a pas besoin d'être réalisé avec précision puisqu'il suffit qu'ils permettent d'obtenir simultanément l'image de la périphérie du trou circulaire et l'image de l'impact du faisceau laser.

Un autre objet de l'invention est de fournir une application du dispositif défini ci-dessus à la réalisation d'une machine d'exposition de panneaux de circuit imprimé pour réaliser le positionnement du panneau de circuit imprimé par rapport au bâti de la machine.

Cette application se caractérise en ce que ladite machine comprend en outre :
- des moyens pour focaliser ledit faisceau laser successivement en deux points du bâti correspondant qui devraient être occupés par les centres des deux trous circulaires,
- des moyens par caméra pour prendre une image des deux trous et des points d'impact de faisceau laser,
- des moyens pour calculer à partir de chacune desdites images les composantes du segment joignant le centre du cercle au point d'impact du faisceau par quoi on obtient deux ensembles d'informations d'erreur de position du panneau,
- des moyens pour déplacer ledit panneau par rapport au bâti au moins en rotation, et des moyens pour commander les moyens de déplacement et les moyens de focalisation du faisceau laser en fonction des deux ensembles d'informations d'erreur de position du panneau.

On comprend que dans ce cas, la référence est constituée par le point d'impact du faisceau laser et que l'élément dont on veut corriger l'erreur de position est le panneau avec ses deux trous de positionnement.

Un autre objet de l'invention est d'appliquer le dispositif de détection défini ci-dessus à la calibration du faisceau laser d'une machine d'exposition de panneaux de circuit imprimé. Cette application se caractérise en ce qu'elle comprend en outre :
- au moins une pièce solidaire dudit bâti, ladite pièce comportant au moins un trou circulaire dont le centre constitue un point de référence du bâti,
- des moyens pour commander les moyens de déflexion de faisceau par des informations de position correspondant à la position du centre dudit cercle,
- des moyens par caméra pour prendre une image dudit trou circulaire et du point d'impact effectif du faisceau laser dans ledit trou,
- des moyens pour calculer les composantes du segment joignant le centre dudit trou au point d'impact du faisceau laser, et des moyens pour transmettre aux moyens de commande des moyens de déflexion lesdites composantes.

On comprend que dans ce cas, la référence de position est constituée par la pièce munie du trou circulaire et l'élément dont on doit déterminer l'erreur de position est le point d'impact du faisceau laser.

D'autres caractéristiques et avantages de l'invention apparaîtront mieux à la lecture de la description qui suit de plusieurs modes de réalisation de l'invention donnés à titre d'exemples non limitatifs. La description se réfère aux figures annexées sur lesquelles :
la figure 1A est une vue en élévation d'un dispositif de mesure d'erreur relative ;
la figure 1B est une vue de dessus partielle du dispositif de mesure d'erreur relative ;
la figure 2 est une vue simplifiée d'une machine d'exposition de panneaux de circuit imprimé comportant un dispositif de positionnement du panneau de circuit imprimé selon l'invention ;
la figure 3 est une vue simplifiée d'une machine d'exposition de panneaux de circuit imprimé équipée d'un dispositif de calibration du faisceau laser de la machine ; et
la figure 4 est une vue schématique d'une machine d'exposition de panneaux de circuit imprimé à plusieurs faisceaux laser.

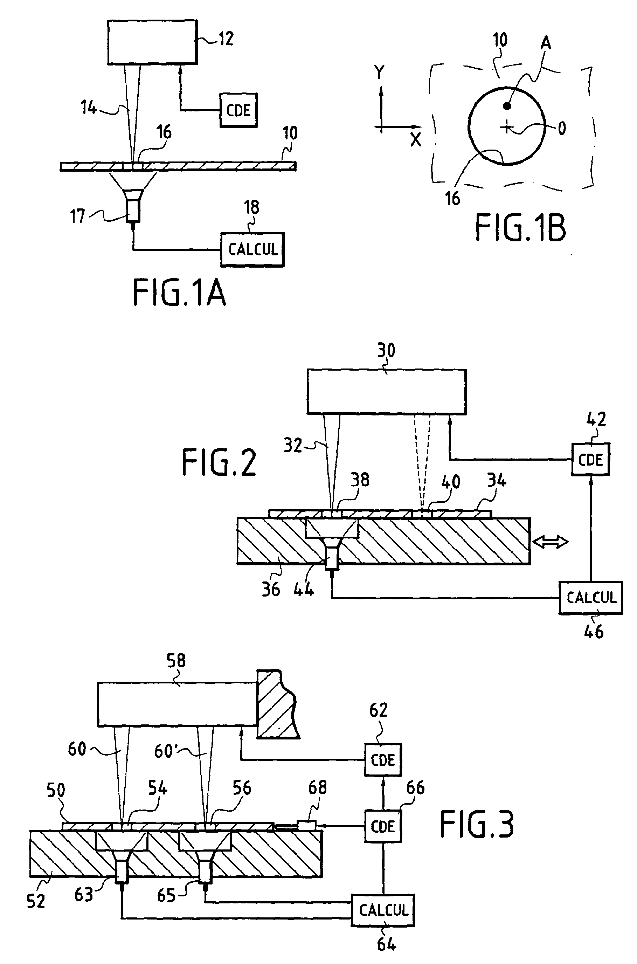

En se référant tout d'abord aux figures 1A et 1B, on va décrire le dispositif de détection et de mesure d'erreur de positionnement relatif d'un faisceau laser et d'une pièce. Sur ces figures, on a représenté une pièce 10 et un système optique 12 pour émettre un faisceau laser 14 vers la pièce 10.

La pièce 10 est munie d'un trou circulaire 16 de centre O, le trou 16 étant lié à cette pièce 10 et en constituant la référence de position. Le dispositif de détection comporte également une caméra 17 disposée de l'autre côté de la pièce 10 par rapport au faisceau laser 14 et capable de prendre une image de la périphérie du trou 16 et du faisceau laser 14. A partir de cette image, un circuit de calcul 18 associé à la caméra permet de calculer les composantes selon les directions orthogonales X et Y du segment qui joint le centre O du cercle et le point d'impact A et donc de déterminer complètement l'erreur de positionnement relative.

Comme on l'a déjà exposé, ce dispositif permet de détecter et de mesurer deux types d'erreur de positionnement absolu selon que le faisceau laser constitue la référence de position et que la pièce 10 est mobile ou que la pièce 10 constitue la référence de position par son trou circulaire 16, le faisceau laser 14 étant alors entaché d'une erreur éventuelle de position.

Il faut bien sûr que la caméra 17 soit capable de détecter le faisceau laser. On pourra choisir une caméra CCD pourvue d'objectifs adaptés aux longueurs d'onde du faisceau laser.

Sur la figure 2, on a représenté l'utilisation du dispositif des figures 1A et 1B à la calibration du faisceau laser par rapport au bâti d'une installation d'exposition. On a représenté un bloc optique 30 dirigeant un faisceau laser 32 vers une pièce 34 solidaire du bâti 36 de la machine. La pièce 34 est par exemple constituée par une réglette solidaire du bâti 36 et réalisée en un matériau d'une grande stabilité telle que de l'Invar. La réglette 34 est munie d'au moins deux orifices circulaires 38 et 40 de diamètre parfaitement défini. Les orifices 38 et 40 constituent donc des références de position du bâti 36. Le bloc optique 30 est associé à un ensemble de commande 42 pour contrôler le point d'impact du faisceau laser.

Pour effectuer la calibration du faisceau laser, on envoie à l'aide du circuit de commande 42 vers le bloc optique 30 des instructions de positionnement du faisceau laser correspondant à la position exacte du trou 34. A l'aide d'une caméra 44, on procède à la prise d'image du trou 38 et du faisceau 32. Le circuit 46 associé à la caméra 44 calcule les erreurs de position comme indiqué précédemment. Du fait que le faisceau laser est positionné en partie à l'aide d'instructions mémorisées dans ses circuits de commande, le calcul d'erreur pourrait être utilisé pour corriger les instructions de commande de positionnement du faisceau laser.

Le faisceau laser devant être déplacé par balayage sur une certaine distance par rapport au bâti, on peut avantageusement répéter l'opération en relation avec un deuxième trou de référence 40 ménagé dans la réglette 34 et en commandant la position du faisceau laser avec des instructions correspondant à la position de ce deuxième trou 40. Cette détermination d'erreur peut être réalisée pour plusieurs trous disposés sur la réglette 34. Ces différentes mesures d'erreur pour différentes positions repérées par la réglette permettent de calculer un polynôme de correction d'erreurs qui permettra de corriger les instructions de balayage par le faisceau pour chaque position de balayage.

En se référant maintenant à la figure 3, on va décrire une application du dispositif de détection d'erreurs relatives au positionnement d'un panneau de circuit imprimé 50 dans une machine d'insolation par faisceau laser. Sur cette figure, on a représenté un bâti 52 de la machine sur lequel est disposé le panneau 50. Ce panneau 50 est pourvu de deux trous de positionnement 54 et 56. Sur cette figure, on a également représenté un bloc optique 58 qui commande le point d'impact d'un faisceau laser 60 en réponse aux instructions transmises par un circuit de commande 62.

Pour réaliser le positionnement du panneau 50 par rapport au bâti 52, on commande le bloc optique 58 de telle façon que le faisceau soit focalisé en un point du bâti correspondant exactement à la position que devrait occuper le centre du trou de positionnement 54. A l'aide de la caméra 63, on prend une image de la périphérie du trou 54 et de l'impact du faisceau laser 60 et l'on calcule les coordonnées de cette erreur dans le circuit de calcul 64. Pour finaliser l'opération de positionnement, le bloc optique 58 est commandé pour qu'un faisceau laser 60' ait un point d'impact correspondant exactement à la position théorique du centre du deuxième trou de positionnement 56 du panneau de circuit imprimé 50. A l'aide d'une deuxième caméra 65, on prend une deuxième image correspondant au trou 56 et on transmet cette deuxième erreur de position au circuit de calcul 64. Ces deux erreurs de position permettent de déterminer des erreurs de position du panneau selon deux directions orthogonales X et Y et en rotation. L'erreur en rotation peut être mesurée par l'angle entre la droite joignant les centres des trous 54 et 56 et la droite joignant les deux points d'impact des faisceaux laser. L'erreur de position en rotation est transmise au circuit de commande 66 d'actuateurs 68 permettant de corriger cette erreur. Les erreurs de position en X et Y sont de préférence directement transmises aux circuits de commande 62 du bloc optique 58.

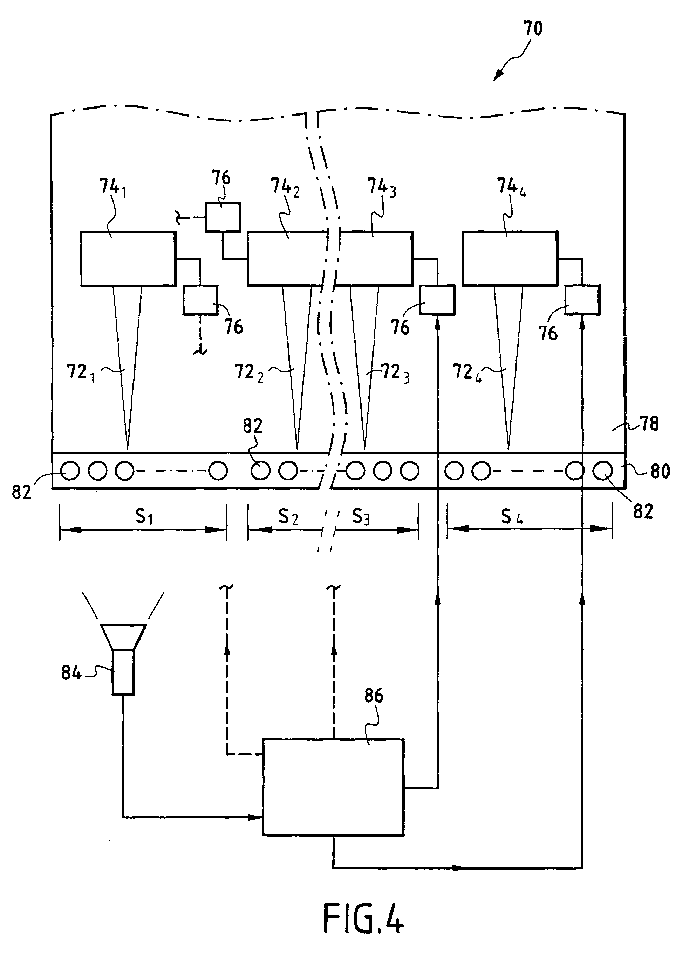

Sur la figure 4, on a représenté le cas d'une machine d'exposition 70 comportant plusieurs faisceaux laser 72₁, 72₂, 72₃, 72₄ produits par autant de blocs optiques 74₁, 74₂, 74₃, 74₄, chaque bloc optique étant commandé par un circuit 76. Pour la calibration des faisceaux laser, le bâti 78 de la machine est équipé d'une règle en Invar 80 comportant autant de séries S₁, S₂, S₃, S₄ de trous 82 de calibration qu'il y a de faisceaux laser à calibrer. Les trous d'une série sont respectivement disposés en regard des zones Z₁, Z₂, Z₃ et Z₄ que doit balayer le faisceau laser ; chaque série comporte par exemple 20 trous.

A l'aide d'une caméra mobile 84, on prend successivement pour chaque trou 82 de chaque série de trous, les images des trous et du faisceau laser et chaque série de trous. Le circuit de calcul 86 élabore alors, pour chaque faisceau laser, un polynôme de correction qui est transmis aux circuits de commande 76 des blocs optiques.

## Revendications

1. Dispositif de mesure d'erreur de position relative entre un faisceau laser et une pièce, **caractérisé**
**en ce que** ladite pièce est munie d'un orifice circulaire occupant une position de référence par rapport à ladite pièce
et **en ce qu'**il comprend en outre :
- des moyens pour focaliser le faisceau laser dans le plan de ladite pièce,
- des moyens pour prendre une image dudit trou circulaire et du faisceau focalisé dans le plan de ladite pièce et des moyens pour calculer les composantes du segment joignant ledit point d'impact et le centre dudit trou.

2. Application du dispositif selon la revendication 1 à la réalisation d'une machine d'exposition de panneaux de circuit imprimé comprenant :
- un bâti fixe apte à recevoir un panneau de circuit imprimé, ledit panneau étant muni d'au moins deux trous circulaires de positionnement,
- au moins un laser associé à des moyens optiques pour focaliser le faisceau laser en un point quelconque du circuit imprimé,
**caractérisée en ce que** ladite machine comprend en outre :
- des moyens pour focaliser ledit faisceau laser successivement en deux points du bâti correspondant qui devraient être occupés par les centres des deux trous circulaires,
- des moyens par caméra pour prendre une image des deux trous et des points d'impact des faisceaux laser,
- des moyens pour calculer à partir de chacune desdites images les composantes du segment joignant le centre du cercle au point d'impact du faisceau par quoi on obtient deux ensembles d'informations d'erreur de position du panneau,
- des moyens pour déplacer ledit panneau par rapport au bâti au moins en rotation, et des moyens pour commander les moyens de déplacement et les moyens de focalisation du faisceau laser en fonction des deux ensembles d'informations d'erreur de position du panneau.

3. Application selon la revendication 2, **caractérisée en ce que** les moyens de calcul déterminent l'angle entre les segments joignant les deux points d'impact des faisceaux laser et les deux centres des trous, ce qui donne une information d'erreur de position en rotation du centre d'un deuxième trou par rapport au centre du premier, et les composantes selon deux directions orthogonales du bâti de l'erreur de position du centre du premier trou, et **en ce que** les moyens de commande comprennent :
- des moyens pour commander les moyens de déplacement en rotation en fonction de l'erreur en rotation calculée, et
- des moyens pour transmettre aux moyens de focalisation desdits faisceaux laser lesdites composantes.

4. Application du dispositif selon la revendication 1 à la réalisation d'une machine d'exposition de panneaux de circuit imprimé comprenant :
- un bâti fixe pour recevoir ledit panneau,
- une source laser pour produire au moins un faisceau laser et des moyens de commande de déflexion du faisceau laser, ladite machine étant **caractérisée en ce qu'**elle comprend en outre :
- au moins une pièce solidaire dudit bâti, ladite pièce comportant au moins un trou circulaire dont le centre constitue un point de référence du bâti,
- des moyens pour commander les moyens de déflexion de faisceau par des informations de position correspondant à la position du centre dudit cercle,
- des moyens par caméra pour prendre une image dudit trou circulaire et du point d'impact effectif du faisceau laser dans ledit trou,
- des moyens pour calculer les composantes du segment joignant le centre dudit trou au point d'impact du faisceau laser, et
- des moyens pour transmettre aux moyens de commande des moyens de déflexion lesdites composantes.

5. Application selon la revendication 4, **caractérisée en ce que** :
ladite pièce comporte une série de trous circulaires dont les centres définissent une série de position de référence du bâti,
**en ce que** les moyens de commande comportent des moyens pour commander successivement les moyens de déflexion du faiscau laser par une série d'informations de position correspondant aux positions des centres de la série de trous,
**en ce que** les moyens par caméra prennent successivement une série d'images pour chaque trou,
**en ce que** les moyens de calcul déterminent lesdites composantes pour chaque image de la série d'images et élaborent une fonction polynomiale de correction de position du faisceau laser à partir de ladite série de composantes en fonction de la position des centres de la série de trous ; et
**en ce que** les moyens de transmission transmettent ladite fonction polynomiale de correction auxdits moyens de commande des moyens de déflexion.

6. Application selon la revendication 5, **caractérisée en ce que**
ladite machine comprend :
- des moyens pour produire une pluralité de faisceaux laser, et
- une pluralité de moyens de déflexion, chaque moyen de déflexion étant associé à un faisceau laser ; chaque moyen de déflexion étant associé à un moyen de commande pour que chaque faisceau laser balaie une portion dudit panneau de circuit imprimé,
**en ce que** ladite pièce comporte une pluralité de séries de trous, chaque série de trous correspondant à la portion de circuit imprimé balayée par ledit faisceau laser, et
**en ce que** lesdits moyens de calcul déterminent une fonction polynomiale de correction de position pour chaque série d'images associée à une série de trous.

## Claims

1. A device for measuring relative position error between a laser beam and a target, the device being **characterised:**
**in that** said target is provided with a circular orifice occupying a reference position relative to said target; and
**in that** the device further comprises:
- means for focusing the laser beam in the plane of said target; and
- means for taking an image of said circular hole and of the beam focused in the plane of said target, and means for calculating the components of the segment between said point of impact and the centre of said hole.

2. The use of the device according to claim 1 to making a machine for exposing printed circuit panels, the machine comprising:
- a fixed structure suitable for receiving a printed circuit panel, said panel being provided with at least two circular positioning holes; and
- at least one laser associated with optical means for focusing said laser beam on an arbitrary point of the printed circuit;
the use being **characterised in that** said machine further comprises:
- means for focusing said laser beam successively on two corresponding points of the structure which ought to be occupied by the centres of the two circular holes;
- camera means for taking respective images of the two holes together with the corresponding points of impact of the laser beams;
- calculator means responsive to each of said images to calculate the components of the segment joining the centre of each circle to the point of impact of the corresponding beam, thereby obtaining two data sets concerning the position error of the panel; and
- panel-displacement means for displacing said panel relative to the structure, at least in rotation, and control means for controlling the panel-displacement means and the means for focusing the laser beam as a function of the two data sets concerning the position error of the panel.

3. A use according to claim 2, **characterised in that** the calculator means determine the angle between the segments joining the two points of impact of the laser beams and the two centres of the holes, thereby obtaining error information concerning position in rotation of the centre of a second hole relative to the centre of the first hole, and the components in two orthogonal directions of the structure of the position error of the centre of the first hole, and **in that** the control means comprise:
- control means for controlling the displacement means in rotation as a function of the calculated rotation error; and
- transmission means for transmitting said components to the means for focusing said laser beams.

4. The use of the device according to claim 1 to making a machine for exposing printed circuit panels, the machine comprising:
- a fixed structure for receiving said panel; and
- a laser source for producing at least one laser beam and means for controlling deflection of the laser beam, said machine being **characterised in that** it further comprises:
- at least one target secured to said structure, said target including at least one circular hole whose centre constitutes a reference point of the structure;
- control means for controlling the beam deflection means on the basis of position information corresponding to the position of the centre of said circle;
- camera means for taking an image of said circular hole and of the actual point of impact of the laser beam in said hole;
- calculator means for calculating the components of the segment joining the centre of said hole to the point of impact of the laser beam; and
- transmission means for transmitting said components to the control means for controlling the beam-deflector means.

5. A use according to claim 4, **characterised in that**:
said target has a series of circular holes whose centres define a series of position references of the structure;
- **in that** the control means include means for controlling the laser beam deflector means successively on the basis of a series of position information data corresponding to the positions of the centres of the series of holes;
- **in that** the camera means take a series of successive images of each hole;
- **in that** the calculator means determine said components for each image in the series of images and generate a polynomial function for correcting the position of the laser beam on the basis of said series of components as a function of the positions of the centres of the series of holes; and
- **in that** the transmission means enable said polynomial correction function to be transmitted to said control means for the deflector means.

6. A use according to claim 5, **characterised in that** said machine comprises:
- means for producing a plurality of laser beams; and
- a plurality of deflector means, each deflector means being associated with a respective laser beam; each deflector means being associated with respective control means so that each laser beam scans a portion of said printed circuit panel;
**in that** said target has a plurality of series of holes, each series of holes corresponding to the portion of the printed circuit scanned by said laser beam; and
**in that** said calculator means determine a polynomial function for correcting position for each series of images associated with a series of holes.

## Patentansprüche

1. Vorrichtung zur Bestimmung eines Positionsfehlers zwischen einem Laserbündel und einem Teil, **dadurch gekennzeichnet,**
**daß** das Teil mit einer kreisförmigen Öffnung versehen ist, die eine Referenzposition in Bezug auf das Teil innehat,
und **daß** sie des weiteren folgendes umfaßt:
- Mittel zum Fokussieren des Laserbündels in der Ebene des Teils,
- Mittel zum Aufnehmen eines Bildes des kreisförmigen Lochs und des fokussierten Bündels in der Ebene des Teils und Mittel zum Berechnen der Komponenten der Strecke, die den Auftreffpunkt und den Mittelpunkt des Lochs verbindet.

2. Verwendung der Vorrichtung nach Anspruch 1 bei der Ausbildung einer Maschine zum Behandeln von plattenförmigem Material für eine gedruckte Schaltung, umfassend:
- ein Gestell, das geeignet ist, eine Platte für die gedruckte Schaltung aufzunehmen, wobei die Platte mit mindestens zwei kreisförmigen Positionierlöchern versehen ist,
- mindestens einen Laser, der mit optischen Mitteln zum Fokussieren des Laserbündels an einem beliebigen Punkt der gedruckten Schaltung verbunden ist,
**dadurch gekennzeichnet, daß** die Maschine des weiteren folgendes umfaßt:
- Mittel zum aufeinanderfolgenden Fokussieren des Laserbündels an zwei Punkten des entsprechenden Gestells, die von den Mittelpunkten der beiden kreisförmigen Löcher besetzt sein sollten,
- Kameramittel, um ein Bild der beiden Löcher und der Auftreffpunkte der Laserbündel aufzunehmen,
- Mittel zum Berechnen, der Komponenten der Strecke, die den Mittelpunkt des Kreises mit dem Auftreffpunkt des Bündels verbindet, von den einzelnen Bildern aus, wodurch man zwei Informationseinheiten über Positionsfehler der Platte erhält,
- Mittel zum Verschieben der Platte zumindest im Drehsinn in Bezug auf das Gestell, sowie Mittel zum Steuern der Mittel zum Verschieben und der Mittel zum Fokussieren des Laserbündels in Abhängigkeit von den beiden Informationseinheiten über Positionsfehler der Platte.

3. Verwendung nach Anspruch 2, **dadurch gekennzeichnet, daß** die Mittel zum Berechnen den Winkel zwischen den Strecken bestimmen, die die beiden Auftreffpunkte der Laserbündel und die beiden Mittelpunkte der Löcher verbinden, was eine Information über den Drehpositionsfehler des Mittelpunktes eines zweiten Lochs in Bezug auf den Mittelpunkt des ersten Lochs und die Komponenten des Positionsfehlers des Mittelpunkts des ersten Lochs gemäß zwei zueinander rechtwinkligen Richtungen des Gestells liefert, und daß die Steuerungsmittel folgendes umfassen:
- Mittel zum Steuern der Mittel zur Verschiebung im Drehsinn in Abhängigkeit von dem berechneten Rotationsfehler, und
- Mittel zur Übermittlung der Komponenten an die Mittel zum Fokussieren der Laserbündel.

4. Verwendung der Vorrichtung nach Anspruch 1 bei der Ausbildung einer Maschine zum Behandeln von plattenförmigem Material für eine gedruckte Schaltung, umfassend:
- ein festes Gestell, um eine Platte aufzunehmen,
- eine Laserquelle, um mindestens ein Laserbündel zu erzeugen, und Steuerungsmittel zur Ablenkung des Laserbündels, wobei die Maschine **dadurch gekennzeichnet ist, daß** sie des weiteren folgendes umfaßt:
- mindestens ein Teil, das mit dem Gestell verbunden ist, wobei das Teil mindestens ein kreisförmiges Loch enthält, dessen Mittelpunkt einen Bezugspunkt des Gestells bildet,
- Mittel zum Steuern der Mittel zur Ablenkung des Bündels durch Informationen über die Position, die der Position des Mittelpunkts des Kreises entspricht,
- Kameramittel zum Aufnehmen eines Bildes des kreisförmigen Lochs und des tatsächlichen Auftreffpunkts des Laserbündels in dem Loch,
- Mittel zum Berechnen der Komponenten der Strecke, die den Mittelpunkt des Lochs mit dem Auftreffpunkt des Laserbündels verbindet, und
- Mittel zur Übermittlung der Komponenten an die Steuerungsmittel der Mittel zur Ablenkung.

5. Verwendung nach Anspruch 4, **dadurch gekennzeichnet, daß**:
das Stück eine Reihe von kreisförmigen Löchern enthält, deren Mittelpunkte eine Reihe von Referenzpositionen des Gestells bestimmen,
daß die Steuerungsmittel Mittel zum aufeinanderfolgenden Steuern der Mittel zur Ablenkung des Laserbündels durch eine Reihe von Informationen über die Positionen, die den Positionen der Mittelpunkte der Reihe von Löchern entsprechen, umfassen,
daß die Kameramittel nacheinander eine Reihe von Bildern für jedes Loch aufnehmen,
daß die Mittel zum Berechnen die Komponenten für jedes Bild der Bilderreihe bestimmen und eine polynomische Funktion zur Korrektur der Position des Laserbündels anhand der Reihe der Komponenten in Abhängigkeit von der Position der Mittelpunkte der Reihe von Löchern erstellen; und
daß die Übertragungsmittel die polynomische Korrekturfunktion an die Mittel zum Steuern der Mittel zur Ablenkung übermitteln.

6. Verwendung nach Anspruch 5, **dadurch gekennzeichnet, daß** die Maschine folgendes umfaßt:
- Mittel zur Erzeugung mehrerer Laserbündel, und
- mehrere Mittel zum Ablenken, wobei jede Mittel zum Ablenken mit einem Laserbündel verbunden sind; wobei jede Mittel zum Ablenken mit einem Mittel zum Steuern verbunden sind, damit jedes Laserbündel einen Abschnitt der Platte mit der gedruckten Schaltung abtastet,
daß das Teil mehrere Reihen von Löchern umfaßt, wobei jede Reihe von Löchern einem Abschnitt der gedruckten Schaltung, die von dem Laserbündel abgetastet wird, entspricht, und
daß die Mittel zum Berechnen eine polynomische Funktion zur Korrektur der Position für jede Bilderreihe, die mit einer Reihe von Löchern in Verbindung steht, bestimmen.
